# EUROPEAN PATENT SPECIFICATION

(11) **EP 1 985 930 B1**
(45) Date of publication and mention of the grant of the patent: **21.10.2009**
(21) Application number: 07008272.2
(22) Date of filing: 24.04.2007
(51) Int. Cl.: F24C 7/08, A47L 15/42

(54) **Control panel for an appliance, especially for a domestic appliance**
Bedienfeld für eine Anwendung, insbesondere für ein Haushaltsgerät
Panneau de commande pour appareil, spécialement pour un appareil domestique

(43) Date of publication of application: 29.10.2008
(73) Proprietor: Electrolux Home Products Corporation N.V., 1930 Zaventem (BE)
(72) Inventor: Winkelmann, Klaus, 63688 Gedern (DE); Taubner, Franz, 91541 Rothenburg (DE)

(56) References cited:
- EP-A- 1 624 101
- EP-A- 1 731 841
- DE-A1- 10 130 198
- DE-A1- 10 218 294
- DE-C1- 19 715 954
- GB-A- 665 210
- GB-A- 2 022 872
- GB-A- 2 169 738
- GB-A- 2 410 541
- US-A1- 2004 226 806
- US-A1- 2005 109 602

## Description

The invention relates to a control panel for an appliance, especially for a domestic appliance, which has at least one switching element, by which at least one parameter of the appliance can be influenced by directly or indirectly actuating and/or touching a front side of the switching element, wherein the switching element has at least one illumination element and wherein the illumination element consists of at least one lamp and at least one reflector element for indirectly lightning of a reverse side of the switching element.

The switching element of an appliance, especially of a domestic appliance, must be illuminated to properly fulfull its function and to be able to clearly switch it even if the environmental illumination conditions are poor. Therefore, illumination means are known by which the switching element can be lightened.

Pre-known applications have a quite complex design so that the costs are relatively high to establish the illumination of the switching element.

An appliance of the kind mentioned above is known from EP 1 624 101 A1. Comparable solutions are shown in DE 197 15 954 C1, in DE 101 30 198 Al, in GB 665 210 A and in GB 2 169 738 A.

Furthermore, another problem is that the illumination of the switching area is not homogeneous enough. This applies specifically when the switching element has a sensor field of substantial size. Often, an illumination appears as a "hot spot", i. e. a certain field of the whole area is intensively illuminated while other regions of the area are quite dark.

This problem can be avoided by employing a plurality of lamps. But this makes the design even more complex and expensive and results in a higher energy consumption.

Therefore, it is an object of the invention to improve a control panel of the kind mentioned above. The illumination of the switching element of the control panel should be homogeneous and cover the whole area of the switching element which has to be illuminated. Furthermore, the design should be as simple as possible to be able to establish the illumination with low costs. It should also become possible to easily divide different sections of the switching element which should be illuminated separately. The number of lamps necessary for illumination should be as less as possible to save energy.

The solution of this object according to the invention is characterized in that the reflector element has a first reflecting zone for reflecting the light from the lamp to a second reflecting zone, which in turn reflexes the light to the switching element, wherein the reflecting zones form a cover which covers the reverse side of the switching element, wherein the lamp comprises at least two LEDs with different colours, wherein the lamp is located at the reverse side of the switching element, wherein the switching element is attached to the glass panel by means of an adhesive foil and wherein the at least one lamp is arranged on the switching element.

The first reflecting zone can be substantially flat shaped. The second reflecting zone can have a concave shape.

The switching element is preferably divided into a plurality of switches. The switches can be arranged side by side. Furthermore, the illumination element can be divided into separate illumination sections according to the number of switches by rib elements. By this is becomes possible that the different fields to be illuminated are clearly separated.

The adhesive foil is preferably transparent.

The switching element can have at least one plug for electrical connection. It is preferably made of a transparent material.

The illumination element and especially the reflector element can be connected to the switching element directly or indirectly by means of a snap-on connection. The reflector element can be coated with a reflecting material at its side facing the switching element.

The switching element can be a capacitive type, an inductive type or the optical type.

By the suggested means a homogeneous illumination of all switches is ensured; no "hot spots" and no dark areas appear. Not further circuit boards are necessary for carrying the lamps. The production of the suggested design is quite easy so that the costs remain low for realizing the control panel.

For a suitable illumination of the respective fields of the switching element only a few number of lamps is necessary. It is easily possible to use different colours and a different brightness for the illumination.

Also the assembly process is quite easy and thus the realization of the panel is cheap.

The different sections of the switching element can easily be separately illuminated.

In the drawings an embodiment of the invention is depicted.
- FIG 1: shows a perspective view of a switching element, seen from the reverse side of it and being equipped with a plurality of switches to be illuminated separately,
- FIG 2: shows a cross sectional view through a control panel equipped with the switching element and the illumination element according to an embodiment of the invention and
- FIG 3: shows the front view of a control panel equipped with the switching element according to FIG 1, seen from the front side.

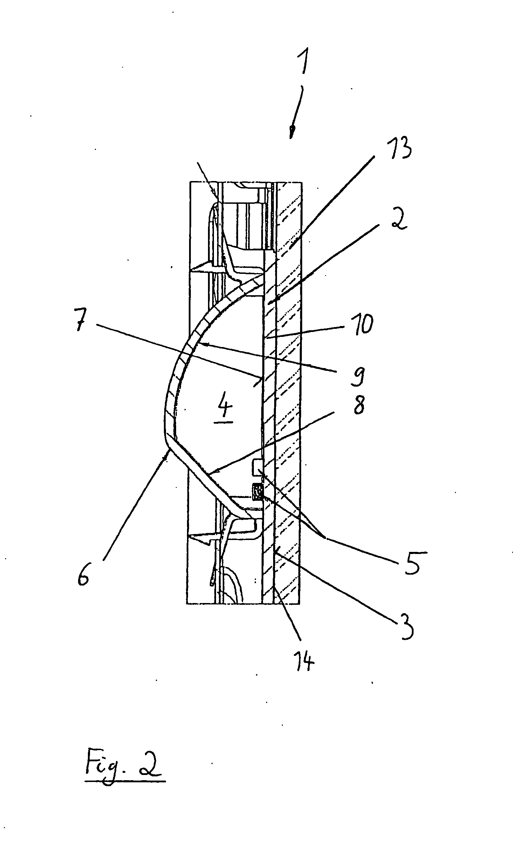

In the figures different views of a control panel 1 and its components are shown. The control panel 1 is a part of a domestic appliance, e. g. of a domestic oven, which uses the control panel to adjust (or to influence) a relevant parameter of the appliance. More specifically, the control panel 1 has a switching element 2 which bears different switches 10, 10', 10'', 10''' by which a switching operation can be carried out. The different switches 10, 10', 10", 10''' can be of the capacitive type, of the inductive type, of the optical type, of an infrared (IR) type or of a funk type. The switching element 2 is made from a transparent material and is connected to a glass panel 13 (see FIG 2) by means of a transparent adhesive foil 14. As the switching element 2, the adhesive foil 14 and the glass panel 13 are transparent, light is visible at a front side 3 of the switching element 2 and thus of the glass panel 13 which is emitted onto a reverse side 7 of the switching element 2.

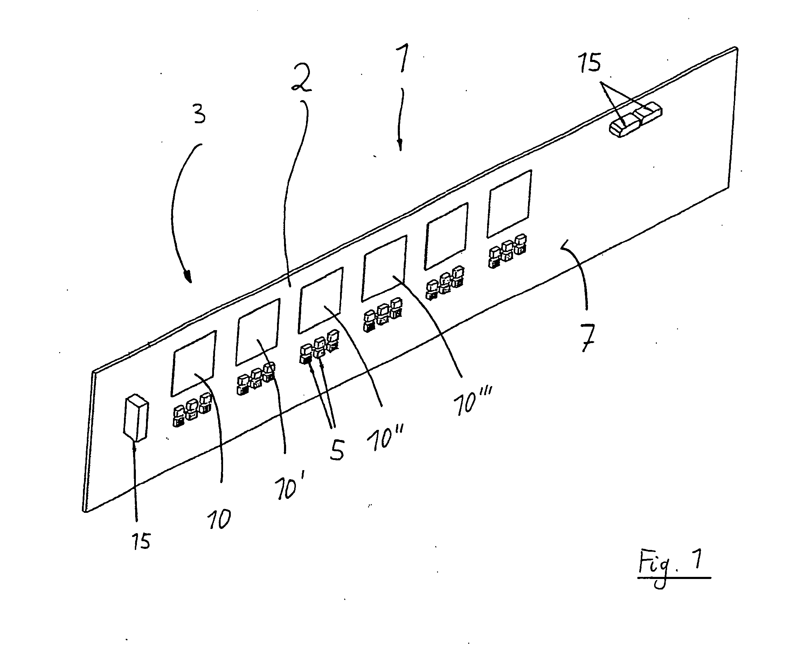

For illuminating the reverse side 7 of the switching element 2 an illumination element 4 is provided. The illumination element 4 consists substantially of a reflector element 6 and of lamps 5. The lamps 5 are mounted directly on the reverse side 7 of the switching element 2 as can be seen best in FIG 1.

The reflector element 6 is connected to the switching element 2 in a suitable manner, e. g. by means of a snap-on connection; it can also be connected to the switching element 2 by any other suitable method. The connection is established in that way that the reflector element 6 contacts always firmly the switching element 2. For this a resilient property of the material can be used.

The reflector element 6 has preferably two different reflecting zones, namely a first reflecting zone 8 and a second reflecting zone 9. The first reflecting zone 8 is substantially flat as can be seen in FIG 2. The second reflecting zone 9 is convex shaped as can also be seen in FIG 2. Thus, light emitted by the lamps 5 is reflected by the first reflecting zone 8 and guided to the second reflecting zone 9. From here it is again reflected to the reverse side 7 of the switching element 2.

The reflector element 6 can be covered with a reflecting coating to improve the reflecting ability.

Thus, the switching element 2 is indirectly illuminated. This has the advantage that "hot spots" as well as dark areas are prevented but the whole illumination section 11, 11', 11'', 11''' of the switch 10, 10' , 10", 10''' is homogeneously illuminated.

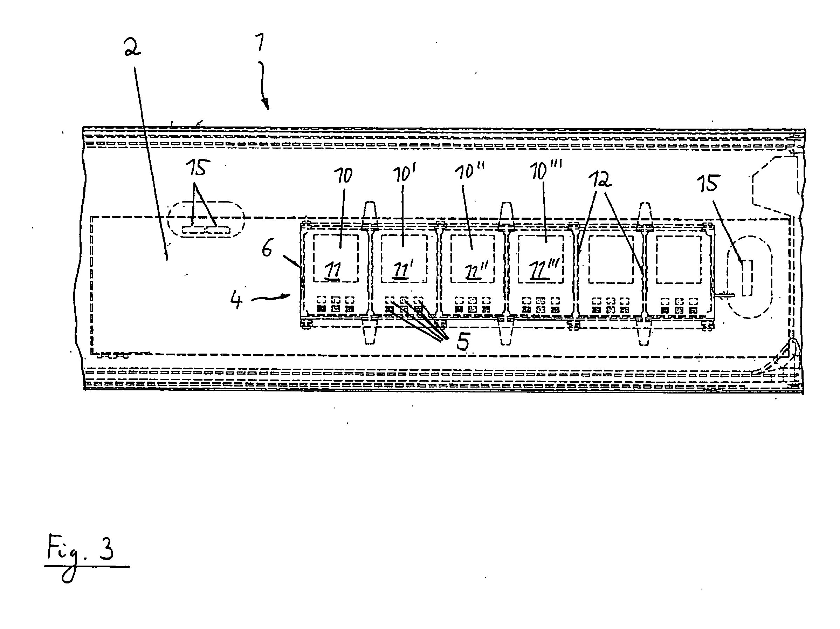

The different illumination sections 11, 11', 11'', 11''' are to be illuminated separately. Therefore, the reflector element 6 is divided into separate sections by means of rib elements 12; see FIG 3. Consequently, when lightening the lamps 5 of a respective illumination section 11, 11', 11'', 11''' only the corresponding switches 10, 10', 10'', 10''' are illuminated.

For the electrical connection of the switching element 2 plugs 15 are provided.

The switching element 2 and more specifically the switches 10, 10', 10'', 10''' can work with any known mechanism, i. e. capacitive, inductive, optical etc. Furthermore, additional components for controlling can be applied on the switching element 2.

As the lamps 5 are located directly of the switching element 2 no further circuit boards as a carrier for the lamps are required.

It is possible to use multiple LEDs (lamps 5) to create different colours and a different brightness. By doing so, is becomes possible e. g. to illuminate all switches 10, 10', 10'', 10''' with a homogeneous basic illumination (here all colours - also white - are possible) which becomes brighter or change the colour when being touched. It is also possible that an additional colour is used within an illumination section 11, 11', 11'', 11''' and thus more than one adjustment of a parameter can be displayed in one switch 10, 10', 10'', 10'''. Of course, it is also possible that the other illumination sections 11, 11', 11'', 11''' get darker or extinguish when one of the sections is touched. Another possibility is that a specific illumination section 11, 11', 11'', 11''' is emphasized to show possible combinations.

### Reference Numerals

- 1: Control panel
- 2: Switching element
- 3: Front side
- 4: Illumination element
- 5: Lamp .
- 6: Reflector element
- 7: Reverse side
- 8: First reflecting zone
- 9: Second reflecting zone
- 10: Switch
- 10': Switch
- 10": Switch
- 10"': Switch
- 11: Illumination section
- 11': Illumination section
- 11": Illumination section
- 11"': Illumination section
- 12: Rib element
- 13: Glass panel
- 14: Adhesive foil
- 15: Plug

## Claims

1. Control panel (1) for an appliance, especially for a domestic appliance, which has at least one switching element (2), by which at least one parameter of the appliance can be influenced by directly or indirectly actuating and/or touching a front side (3) of the switching element (2), wherein the switching element (2) has at least one illumination element (4) and wherein the illumination element (4) consists of at least one lamp (5) and at least one reflector element (6) for indirectly lightning of a reverse side (7) of the switching element (2), whereby
the reflector element (6) has a first reflecting zone (8) for reflecting the light from the lamp (5) to a second reflecting zone (9), which in turn reflexes the light to the switching element (2),
**characterised in that**
the reflecting zones (8, 9) form a cover which covers the reverse side (7) of the switching element (2),
wherein the lamp (5) comprises at least two LEDs with different colours,
wherein the lamp (5) is located at the reverse side (7) of the switching element (2),
and whereby the control panel (1) further comprises a glass panel (13) and an adhesive foil (14), whereby
the switching element (2) is attached to the glass panel (13) by means of the adhesive foil (14) and wherein the at least one lamp (5) is arranged on the switching element (2).

2. Control panel according to claim 1, **characterized in that** the first reflecting zone (8) is substantially flat shaped.

3. Control panel according to claim 1 or 2, **characterized in that** the second reflecting zone (9) has a concave shape.

4. Control panel according to at least one of claims 1 to 3, **characterized in that** the switching element (2) is divided into a plurality of switches (10, 10', 10'', 10''').

5. Control panel according to claim 4, **characterized in that** the switches (10, 10', 10'', 10''') are arranged side by side.

6. Control panel according to claim 4 or 5, **characterized in that** the illumination element (4) is divided into separate illumination sections (11, 11', 11'', 11''') according to the number of switches (10, 10', 10'', 10''') by rib elements (12).

7. Control panel according to at least one of claims 1 to 6, **characterized in that** the adhesive foil (14) is transparent.

8. Control panel according to at least one of claims 1 to 7, **characterized in that** the switching element (2) has at least one plug (15) for electrical connection.

9. Control panel according to at least one of claims 1 to 8, **characterized in that** the switching element (2) is made from a transparent material.

10. Control panel according to at least one of claims 1 to 9, **characterized in that** the illumination element (4) is connected to the switching element (2) directly or indirectly by means of a snap-on connection.

11. Control panel according to at least one of claims 1 to 10, **characterized in that** the reflector element (6) is coated with a reflecting material at its side facing the switching element (2).

12. Control panel according to at least one of claims 1 to 11, **characterized in that** the switching element (2) is of the capacitive type.

13. Control panel according to at least one of claims 1 to 11, **characterized in that** the switching element (2) is of the inductive type.

14. Control panel according to at least one of claims 1 to 11, **characterized in that** the switching element (2) is of the optical type.

## Patentansprüche

1. Schaltfeld (1) für ein Gerät, insbesondere für ein Haushaltsgerät, das mindestens ein Schaltelement (2) aufweist, mit dem mindestens ein Parameter des Geräts beeinflusst werden kann, indem eine Vorderseite (3) des Schaltelements (2) direkt oder indirekt betätigt und/oder berührt wird, wobei das Schaltelement (2) mindestens ein Leuchtelement (4) aufweist und wobei das Leuchtelement (4) aus mindestens einer Lampe (5) und mindestens einem Reflektorelement (6) zur indirekten Beleuchtung einer Rückseite (7) des Schaltelements (2) zusammengesetzt ist, wobei das Reflektorelement (6) eine erste Reflexionszone (8) zur Reflexion des von der Lampe (5) kommenden Lichts zu einer zweiten Reflexionszone (9) aufweist, die ihrerseits das Licht auf das Schaltelement (2) reflektiert, **dadurch gekennzeichnet, dass** die Reflexionszonen (8, 9) eine Abdeckung bilden, die die Rückseite (7) des Schaltelements (2) abdeckt, wobei die Lampe (5) mindestens zwei LEDs mit unterschiedlichen Farben umfasst, wobei die Lampe (5) an der Rückseite (7) des Schaltelements (2) angeordnet ist und wobei das Schaltfeld (1) ferner eine Glasplatte (13) und eine Klebefolie (14) umfasst, wobei das Schaltelement (2) an der Glasplatte (13) mittels der Klebefolie (14) befestigt ist und wobei die mindestens eine Lampe (5) auf dem Schaltelement (2) angeordnet ist.

2. Schaltfeld gemäß Anspruch 1, **dadurch gekennzeichnet, dass** die erste Reflexionszone (8) im wesentlichen flach geformt ist.

3. Schaltfeld gemäß Anspruch 1 oder 2, **dadurch gekennzeichnet, dass** die zweite Reflexionszone (9) eine konkave Form aufweist.

4. Schaltfeld gemäß mindestens einem der Ansprüche 1 bis 3, **dadurch gekennzeichnet, dass** das Schaltelement (2) in eine Mehrzahl von Schaltern (10, 10', 10'', 10''') unterteilt ist.

5. Schaltfeld gemäß Anspruch 4, **dadurch gekennzeichnet, dass** die Schalter (10, 10', 10'', 10''',...) nebeneinander angeordnet sind.

6. Schaltfeld gemäß Anspruch 4 oder 5, **dadurch gekennzeichnet, dass** das Leuchtelement (4) durch Stegelemente (12) in separate Leuchtabschnitte (11, 11', 11'', 11''') nach Maßgabe der Anzahl der Schalter (10, 10', 10", 10''') unterteilt ist.

7. Schaltfeld gemäß mindestens einem der Ansprüche 1 bis 6, **dadurch gekennzeichnet, dass** die Klebefolie (14) transparent ist.

8. Schaltfeld gemäß mindestens einem der Ansprüche 1 bis 7, **dadurch gekennzeichnet, dass** das Schaltelement (2) mindestens einen Stecker (15) für den elektrischen Anschluss hat.

9. Schaltfeld gemäß mindestens einem der Ansprüche 1 bis 8, **dadurch gekennzeichnet, dass** das Schaltelement (2) aus einem transparentem Material gefertigt ist.

10. Schaltfeld gemäß mindestens einem der Ansprüche 1 bis 9, **dadurch gekennzeichnet, dass** das Leuchtelement (4) direkt oder indirekt mittels einer Aufsteckverbindung an das Schaltelement (2) angeschlossen ist.

11. Schaltfeld gemäß mindestens einem der Ansprüche 1 bis 10, **dadurch gekennzeichnet, dass** das Reflektorelement (6) mit einem reflektierenden Material an seiner Seite beschichtet ist, das dem Schaltelement (2) zugewandt ist.

12. Schaltfeld gemäß mindestens einem der Ansprüche 1 bis 11, **dadurch gekennzeichnet, dass** das Schaltelement (2) vom kapazitiven Typ ist.

13. Schaltfeld gemäß mindestens einem der Ansprüche 1 bis 11, **dadurch gekennzeichnet, dass** das Schaltelement (2) vom induktiven Typ ist.

14. Schaltfeld gemäß mindestens einem der Ansprüche 1 bis 11, **dadurch gekennzeichnet, dass** das Schaltelement (2) vom optischen Typ ist.

## Revendications

1. Panneau de commande (1) pour un appareil, en particulier un appareil domestique, qui possède au moins un élément de commutation (2) au moyen duquel on peut agir sur au moins un paramètre de l'appareil en actionnant et/ou touchant directement ou indirectement un côté avant (3) de l'élément de commutation (2), où l'élément de commutation (2) possède au moins un élément d'éclairage (4) et où l'élément d'éclairage (4) consiste en au moins une lampe (5) et au moins un élément réflecteur (6) pour éclairer indirectement un côté arrière (7) de l'élément de commutation (2), par quoi
l'élément réflecteur (6) possède une première zone de réflexion (8) pour réfléchir la lumière de la lampe (5) vers une deuxième zone de réflexion (9) qui, à son tour, réfléchit la lumière à l'élément de commutation (2), **caractérisé en ce que**
les zones de réflexion (8, 9) forment un couvercle qui couvre le côté arrière (7) de l'élément de commutation (2), où la lampe (5) comprend au moins deux DELs de couleurs différentes,
où la lampe (5) se situe au côté arrière (7) de l'élément de commutation (2), et par quoi le panneau de commande (1) comprend en outre un panneau en verre (13) et une feuille adhésive (14), par quoi
l'élément de commutation (2) est fixé au panneau en verre (13) au moyen de la feuille adhésive (14), et où la au moins une lampe (5) est agencée sur l'élément de commutation (2).

2. Panneau de commande selon la revendication 1, **caractérisé en ce que** la première zone de réflexion (8) a une forme sensiblement plate.

3. Panneau de commande selon la revendication 1 ou 2, **caractérisé en ce que** la deuxième zone de réflexion (9) possède une forme concave.

4. Panneau de commande selon au moins l'une des revendications 1 à 3, **caractérisé en ce que** l'élément de commutation (2) est divisé en une pluralité de commutateurs (10, 10', 10", 10''').

5. Panneau de commande selon la revendication 4, **caractérisé en ce que** les commutateurs (10, 10', 10", 10"') sont agencés côte à côte.

6. Panneau de commande selon la revendication 4 ou 5, **caractérisé en ce que** l'élément d'éclairage (4) est divisé en des sections d'éclairage séparées (11, 11', 11", 11''') selon le nombre de commutateurs (10, 10', 10", 10''') par des éléments nervurés (12).

7. Panneau de commande selon au moins l'une des revendications 1 à 6, **caractérisé en ce que** la feuille adhésive (14) est transparente.

8. Panneau de commande selon au moins l'une des revendications 1 à 7, **caractérisé en ce que** l'élément de commutation (2) possède au moins un connecteur (15) pour la connexion électrique.

9. Panneau de commande selon au moins l'une des revendications 1 à 8, **caractérisé en ce que** l'élément de commutation (2) est réalisé en un matériau transparent.

10. Panneau de commande selon au moins l'une des revendications 1 à 9, **caractérisé en ce que** l'élément d'éclairage (4) est relié à l'élément de commutation (2) directement ou indirectement par une connexion à encliquetage.

11. Panneau de commande selon au moins l'une des revendications 1 à 10, **caractérisé en ce que** l'élément réflecteur (6) est revêtu d'un matériau réfléchissant à son côté orienté vers l'élément de commutation (2).

12. Panneau de commande selon au moins l'une des revendications 1 à 11, **caractérisé en ce que** l'élément de commutation (2) est du type capacitif.

13. Panneau de commande selon au moins l'une des revendications 1 à 11, **caractérisé en ce que** l'élément de commutation (2) est du type inductif.

14. Panneau de commande selon au moins l'une des revendications 1 à 11, **caractérisé en ce que** l'élément de commutation (2) est du type optique.
